# EUROPEAN PATENT SPECIFICATION

(11) **EP 1 589 407 B1**
(45) Date of publication and mention of the grant of the patent: **10.10.2007**
(21) Application number: 04101674.2
(22) Date of filing: 22.04.2004
(51) Int. Cl.: G06F 3/033

(54) **Control interface for electronic device**
Steuerschnittstelle für ein elektronisches Gerät
Interface de contrôle pour dispositif électronique

(43) Date of publication of application: 26.10.2005
(73) Proprietor: Sony Ericsson Mobile Communications AB, 221 88 Lund (SE)
(72) Inventor: KLINGHULT, Gunnar, 223 78, Lund (SE)
(74) Representative: Lindberg, Olle Nils Olof

(56) References cited:
- DE-U- 20 311 137
- US-A1- 2002 186 209

## Description

### Field of the invention

The present invention relates to man-machine interfaces for electronic devices, and more specifically to data input interfaces for e.g. data communication or processor devices, such as mobile phones and computers, or electronic media players or recorders. In particular, the invention relates to touch-sensitive input devices.

### Background

The use of electronic devices with control input capabilities, such as computers, mobile phones, and audio/video equipment, has had enormous development in the world in the last decades. Traditionally, keyboards or keypads have been used for entering data and control commands into such electronic equipment. Auxiliary input means include joysticks or jog balls, and voice-controlled systems. Data output from the electronic devices is mainly provided by means of displays, on which images, text, and numbers are visualised.

A lot of effort has been made in making smaller electronic devices, in particular for portable use, such as mobile phones, laptop computers, Personal Digital Assistants (PDA), mp3 players, and so on. Much help has been obtained from the miniaturisation of electronic components and the development of more efficient batteries. In mobile communications, the communication systems have gone from analogue to digital, and at the same time the dimensions of the communication terminals have gone from briefcase size to the pocket size phones of today, in only a couple of decades. Numerous manufacturers now offer pocket-sized terminals with a wide variety of capabilities and services, such as packet-oriented transmission and multiple radio band coverage. Still today, mobile phones are getting smaller and smaller and the size is generally considered to be an important factor for the end customer. Built-in antennas of different types have eliminated the need for protruding antenna elements. At the same time, terminals are becoming increasingly capable of performing more advanced functions and services, both due to the development of the terminals and the network systems. The development of new transmission schemes, the so-called 3^{rd} generation mobile system currently being implemented and the 4^{th} generation to be expected within ten years, also provides the possibility to convey more advanced data to the wireless communication terminals, such as real time video.

Regarding mobile phones as well as portable computers and media players, the end users have a number of conflicting requirements. Basically, the device should be as small and light-weight as possible. Furthermore, it should provide more and more advanced functions, have a long battery time, and have a user-friendly interface. Still, there is only so much space in an electronic device, and in order to be competitive the elements of the devised must be carefully packaged.

In recent years, the use of touch-sensitive devices for input interfaces has increased rapidly. A trend within the fields of electronic equipment is to implement larger displays serving as data output interfaces, which is particularly interesting with radio transmission schemes which make it possible to transmit and present video. Furthermore, such displays are also often touch-sensitive and serve as data input interfaces, preferably operated by means of a pen-like stylus. Touch-sensitive input means are also used without combination with output means, such as in the iPOD MP3 player from Apple®. This particular state of the art device is devised with a ring-shaped input area, which may be used for scrolling menus by moving a finger in contact with the surface. By dividing the ring-shaped surface in sector portions, each sector portion may represent one step in a scrolling function.

Touch-sensitive input devices may e.g. work with capacitive technology, where a particular portion of an input surface comprises an electrode of a conductive material. As a user's finger touches or comes sufficiently near the electrode, the capacitance of the electrode changes, which change is picked up by a capacitance sensing circuit.

A man machine interface which involves the combination of an input device with an output device in a touch-sensitive display is generally experienced as very user friendly, particularly due to the intuitive correlation between data input and data output. However, such a touch-sensitive display typically involves a relatively large display, compared to a pure output display. Furthermore, displays are relatively expensive components compared to keypads, and with increased display dimensions comes higher production cost.

DE 20311137U discloses a self-luminous, capacitive contact-sensitive display, which has output unit in form of self-luminous an OLED (Organic Light Emitting Diode) display on a rear side of a substrate-bearer plate, and capacitive contact-sensitive input facility on its front side.

### Summary of the invention

It is an object of the present invention to provide data input means for electronic devices, such as mobile phones, PDA's, laptop computers, and media players, which has an intuitive and user friendly design. Furthermore, it is an object to provide a design for data input means which is suitable for implementation in compact portable electronic devices, implying that advantageous aspects are small size and low weight.

According to a first aspect, this object is fulfilled by an input interface for an electronic device, comprising a touch-sensitive input detection layer, and an input sensor connected to said layer for detecting touch-generated capacitance variations in said detection layer. According to the invention, said detection layer is transparent, and in that a polymer layer of a polymer light emitting diode is disposed under said detection layer and devised to emit light through said detection layer. The polymer layer is sandwiched between a pair of conductive electrode layers of said polymer light emitting diode, wherein said detection layer forms one of said pair of electrode layers.

In one embodiment, said detection layer is an anode for said light emitting diode.

In a preferred embodiment, said detection layer comprises an indium-tin-oxide substrate.

In one embodiment, said polymer layer comprises an undoped conjugated polymer.

Preferably, said input sensor is coupled to said detection layer through a DC-voltage blocking capacitor.

In one embodiment, said detection layer is coupled to a switch, which switch is coupled to said input sensor and to a drive unit for said polymer light emitting diode, which switch is devised to switch between connecting said detection layer to either said input sensor or said drive unit.

Preferably, a transparent protective layer is disposed over said detection layer.

In one embodiment, a control unit is connected to said input sensor and to a drive unit for said polymer light emitting diode, which control unit is devised to control said drive unit to activate light emission from said polymer light emitting diode dependent on an input signal sensed by said input sensor.

Preferably, said detection layer comprises a plurality of separate segments representing separate input areas.

In one embodiment, a continuous polymer layer of said polymer light emitting diode is disposed under said plurality of separate segments of the detection layer.

In an alternative embodiment, separate polymer layer portions are disposed under said plurality of separate segments of the detection layer.

According to a second aspect, the object of the present invention is fulfilled by an electronic device comprising an input interface, said interface including a touch-sensitive input detection layer, and an input sensor connected to said layer for detecting touch-generated capacitance variations in said detection layer. According to the invention, said detection layer is transparent, and in that polymer layer of a polymer light emitting diode is disposed under said detection layer and devised to emit light through said detection layer.

Preferably, said polymer layer is sandwiched between a pair of conductive electrode layers of said polymer light emitting diode, wherein said detection layer forms one of said pair of electrode layers.

Furthermore, the electronic device is preferably devised with any of the features mentioned above.

In one embodiment, said electronic device includes a radio communication terminal.

In another embodiment, said electronic device includes a media player.

### Brief description of the drawings

The present invention will now be described in more detail with reference to preferred embodiments, given only by way of example and illustrated in the accompanying drawings, in which:
Fig. 1 schematically illustrates the basic structure of a type of polymer light emitting diode on which an embodiment of the invention may be based;
Fig. 2 schematically illustrates an embodiment of an input interface according to the present invention;
Fig. 3 schematically illustrates another embodiment of an input interface according to the present invention;
Fig. 4 schematically illustrates a portion of one embodiment of an input interface comprising plural input areas;
Fig. 5 schematically illustrates a portion of another embodiment of an input interface comprising plural input areas;
Fig. 6 schematically illustrates a portion of yet another embodiment of an input interface comprising plural input areas; and
Fig. 7 schematically illustrates an electronic device incorporating an embodiment of an input interface according to the present invention.

### Detailed description of preferred embodiments

The present description relates to the field of input interfaces for electronic devices, such as data communication and processing devices, radio communication terminals, and media players. The electronic devices referred to in this disclosure includes all mobile equipment devised for radio communication with a radio station, which radio station also may be mobile terminal or e.g. a stationary base station. Consequently, the term terminal includes data communication devices such as mobile telephones, pagers, communicators, electronic organisers, smartphones, PDA:s (Personal Digital Assistants) and DECT terminals (Digital Enhanced Cordless Telephony). The invention is also applicable to computers, e.g. laptops, which are included in the electronic device used herein. Although the invention is particularly suitable for portable devices, where low weight and small dimensions are relevant parameters, the invention may equally well be included in stationary devices, such as desktop computers, wire-bound telephones, hi-fi equipment, and so on. Furthermore, it should be emphasised that the term comprising or comprises, when used in this description and in the appended claims to indicate included features, elements or steps, is in no way to be interpreted as excluding the presence of other features elements or steps than those expressly stated.

Preferred embodiments will now be described with reference to the accompanying drawings.

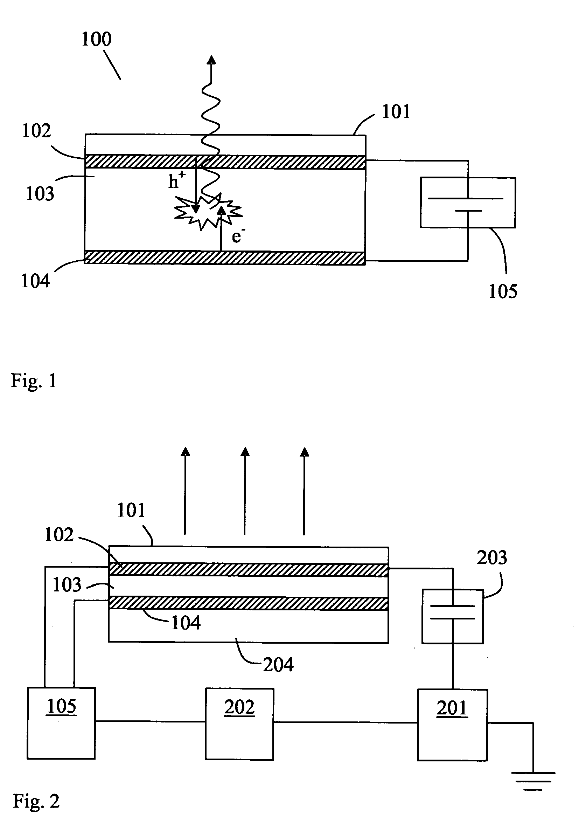

Fig. 1 illustrates a polymer film light emitting diode 100, the technology of which is used in the present invention. Such a type of device is generally referred to as a Polymer Light Emitting Diode PLED, or an Organic Light Emitting Diode OLED. PLED is a backlighting, illumination and display technology which has had an enormous development during recent years, and the basic function is described with reference to Fig. 1. A PLED comprises a thin layer 103 of polymer, preferably an undoped conjugated polymer, which is sandwiched between an anode 102 and a cathode 104. Examples of polymers which have been used in different applications include poly-p-phenylene vinylene (PPV), poly-p-phenylenebenzobisthiazole (PBT) and poly-p-phenylenebenzobis- oxazole (PBO). The polymer of layer 103 emits light when exposed to electricity. When electrons e⁻ and holes h⁺ are injected respectively from cathode 104 and anode 102 into the molecular polymer layer or layers 103 by means of a bias voltage supplied by a DC driver unit 105, these two types of carriers migrate towards each other and a fraction of them recombine to form light emission.

At least one of the electrodes 102, 104 is transparent to the emitted light, in general the anode 102. In one typical embodiment, anode 102 is a substrate of transparent indium-tin-oxide (ITO), whereas the cathode 104 may be a layer of aluminium. In various types of PLEDs described in the prior art, additional layers of material may be included between the electrodes 102, 104, e.g. for enhancing the electron or the hole injection efficiency. It has for instance been proposed to insert a thin layer of LiF, Al2O3 or Ca between polymer layer 103 and cathode 104 to enhance the electron injection efficiency. A transparent protective layer 101 is preferably applied over the anode 102. In reality, the protective layer 101 is often a glass substrate, whereas the ITO substrate is used as a base on which the other layers are applied by spinning and evaporation deposition, in a manner well known to the skilled person.

Fig. 2 illustrates an embodiment of an input interface according to the invention. The input interface involves a touch-sensitive detection input layer 102, which is connected to an input sensor 201. In a preferred embodiment, detection layer 102 is a conductive electrode and input sensor 201 is devised to apply an alternating current AC to the detection layer 102, which forms part of a tuned circuit with a certain resonance frequency. When a user touches or places e.g. a finger near the outer surface of the input interface, which outer surface is defined by detection layer 102 or in a preferred embodiment by a protection layer 101, the capacitance of detection layer 102 is affected. The change in the capacitance will in turn affect the tuned circuit, and by monitoring the frequency or the frequency shift of the AC current, input sensor 201 may detect input by touch-sensing.

According to the invention, the input interface further includes a PLED, or OLED, devised to provide backlighting from behind the detection layer. The PLED includes a polymer layer 103, an upper electrode 102 which is transparent, and a lower electrode 104. Preferably, upper electrode 102 is an anode and lower electrode 104 is a cathode, but the opposite is also possible. The electrodes 102 and 104 are connected to a driver unit 105, devised to apply a DC voltage over polymer layer 103, such that light is emitted though the transparent upper electrode 102 and the protective layer, indicated by arrows in the drawing. Protective layer 101 may, as mentioned above, be made of glass, but in a preferred embodiment a layer of transparent plastic is preferably used. By using PLED technology for backlighting and capacitance-dependent input touch sensing, an input interface is obtained which is compact with a low profile and low weight. Furthermore, both the touch-sensitive input detection layer 102 and the PLED are thin and flexible, and the combination of these elements may therefore be used for creating curved interfaces with built-in backlighting. The PLED is preferably applied on a support substrate 204. For an embodiment where an electronic unit includes a traditional keypad as an auxiliary input interface, support substrate 204 may be a keypad math on which keys of the keypad are attached according to the prior art.

According to a preferred embodiment of the invention, upper electrode 102 of the PLED is used as the detection layer for input detection. This way, fewer components or layers are needed, which saves space and potentially also production cost and production time. Preferably, detection layer 102 is connected to input sensor 201 over a DC-voltage blocking capacitor 203, such that the DC coupling of driver unit 105 is not connected to input sensor 201.

In a more advanced version of this embodiment, a control unit 202 is connected to correlate sensed input with light emission. Control unit 202 may e.g. form part of a microprocessor system with associated operating system and application software. Preferably, control unit connects to both input sensor 201 and the PLED driver unit 105. In one embodiment, control unit 202 is devised to:
- detect if an input signal has been sensed by input sensor 201, i.e. if a user has touched or nearly touched an input surface defined by the coverage of detection layer 102;
- trig driver unit 105 to apply a DC voltage over electrodes 102 and 104 upon such detection;
- wherein touch-generated input causes lighting of the input surface.

In a variant of that embodiment, sensed input may be used to alter the colour of the emitted light, i.e. the wavelength. Yet another option is for control unit 202 to turn off the PLED upon detected input, or to turn to a blinking light.

In any case, these embodiments of the present invention bring about a very direct feedback.

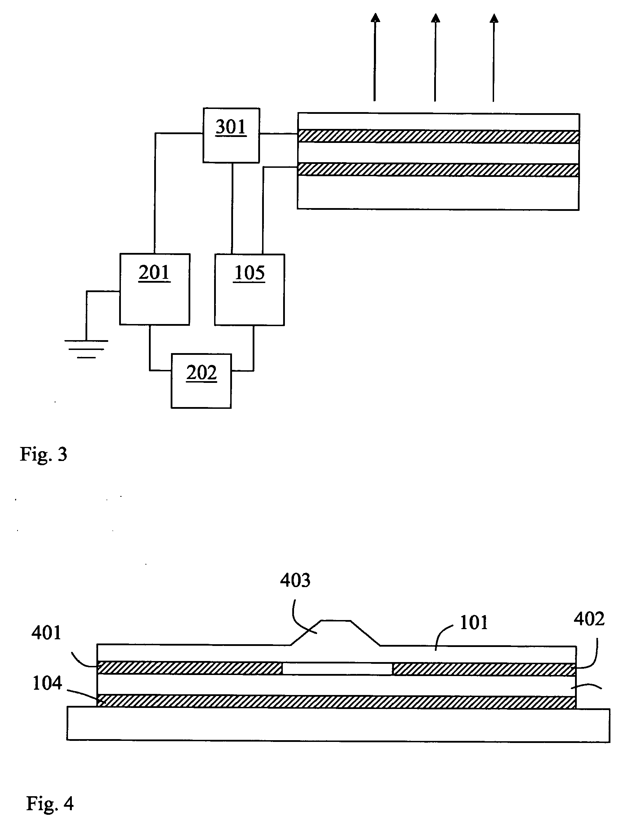

Fig. 3 illustrates a variant of the embodiment of Fig. 2. Like elements of the PLED, including the combined electrode and detection layer, are the same as in Fig. 2, wherefore no reference markings have been included. The capacitive coupling 203 has been left out, but may optionally be included. In this embodiment, the input sensor 201 and the driver unit 105 for the PLED are connected in a different way.. More specifically, a common connection to detection layer/electrode 102 is used, which saves wiring. A fast multiplexing switch 301 is connected to the common detection layer 102, which switch in turn is connected to driver unit 105 and to input sensor 201. According to this embodiment, switch 301 is devised to switch between driving the PLED and applying an AC for detecting input signals. As for the embodiment of Fig. 2, a control unit 202 may be employed for correlating input signals with light emission by means of the PLED.

Fig. 4 illustrates the PLED with its upper electrode 102 used also for input signal detection, without the associated circuits shown in Figs 1-3, for the sake of simplicity. Fig. 4 illustrates how a single polymer layer 103 is used with a single cathode 104, and two different anodes 401 and 402. A common protective layer 101 is applied over both anodes 401 and 402. As an optional feature, Fig. 4 further illustrates a raised rib 403 in the upper protective layer 101, indicating a border between electrodes 401 and 402. This feature may be included to distinguish separate input areas. An alternative to a rib may be a groove.

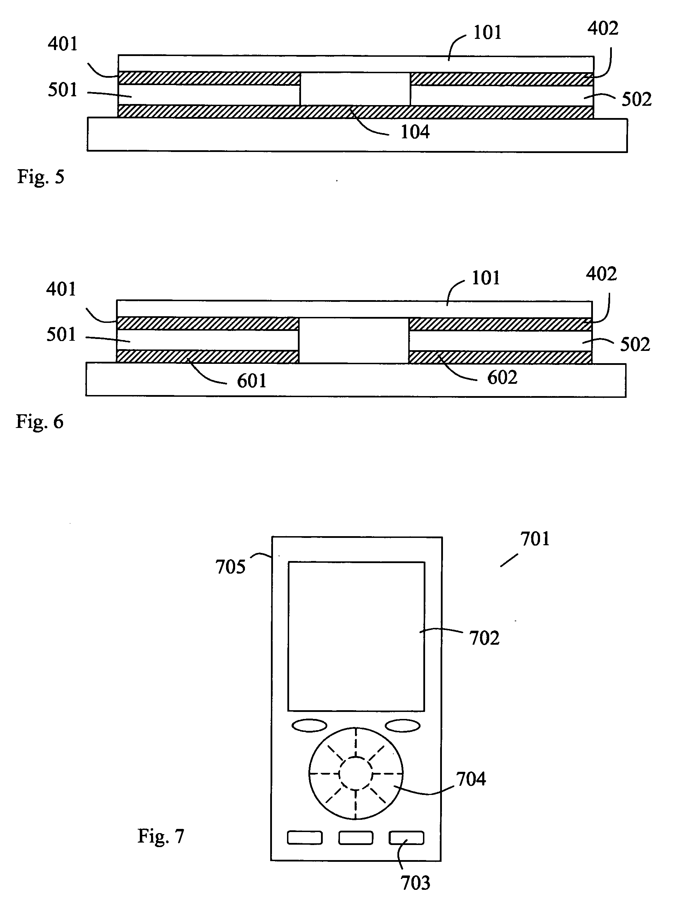

Fig. 5 shows an embodiment similar to that of Fig. 4, but where separate polymer layers 501 and 502, respectively, are used under separate electrodes 401 and 402, respectively. In the embodiment of Fig. 5, a common cathode 104 is still used.

Fig. 6 illustrates yet another embodiment similar to that of Fig. 5, with separate polymer layers 501 and 502 used under separate electrodes 401 and 402. In the embodiment of Fig. 6, separate cathodes 601 and 602, respectively, are also used.

Anodes 401 and 402 are, in the embodiments of Figs 4-6, connected to separate input sensors, optionally to different ports of a common input sensor. In the same manner, anodes 401 and 402 are connected to different DC drivers or different ports of a common DC driver. Furthermore, separate connections according to the embodiment of Fig. 2 may be used, or connections through switches according to the embodiment of Fig. 3 may be used. The rib 403 in Fig. 4 may of course also be used in the embodiments of Figs 5 and 6. The embodiments of Figs 4-6 illustrate simple ways of including two or more input areas, defined by the coverage area of the respective anodes 401 and 402, which different areas may function as different keys.

In the illustrated embodiments, connection to the electrodes may be achieved by means of bonded wires or flex cables.

Fig. 7 illustrates an electronic device 701 in the form of a radio communication terminal, such as a mobile phone, in which the input interface according to an embodiment of the invention is included. Terminal 701 comprises a chassis or housing 705, carrying a user audio input in the form of a microphone and a user audio output in the form of a loudspeaker (not shown). A data output interface comprising a display 702 is further included, devised to display communication information, address list etc in a manner well known to the skilled person. Terminal 701 includes radio transmission and reception electronics (not shown), and is devised with a built-in antenna inside housing 705. A set of keys 703 may be included as a data input interface, usable e.g. for dialling, according to the established art. However, for input of data and command signals, an input interface according to the present invention is also comprised. In this embodiment, the input interface which combines a touch-sensitive area with a PLED for backlighting in accordance with the invention, is devised as a circular surface 704. Dashed lines indicate separations between separate input surface portions, which corresponds to different electrodes 401 and 402 as illustrated in any of Figs 4-6. The separations may be invisible to a user, by including a flat protective layer 101. Alternatively, ribs or grooves may be employed to provide a detectable distinction between the input areas. In the illustrated embodiment, which should be regarded as a mere example, input interface 704 comprises segments of a ring-shaped portion, and a central portion. Such an input interface may e.g. be used for scrolling in menus, by moving a finger in one or the other direction around the ring-shaped portion, whereas the centre portion may be used for initiating a call, or as a phone lift function when responding to a call. Such an interface has previously been implemented in e.g. the portable telephones of the Beocom 6000 series from Bang&Olufsen, and a similar approach has been used in the previously mentioned iPOD. However, the input interface of the present invention brings about a further technical effect to those prior art solutions, with backlighting, and preferably with combined usage of the uppermost electrodes for touch-sensing and for driving the PLEDs.

The use of PLEDs according to the present invention, brings about several advantages. The PLED is made of a foil, and gives an area of light compared to conventional LEDs, giving a spot of light. All colours are possible, including white and RGB. It is also possible to design non-planar input interfaces with the design according to the present invention. The viewing angle dependence is excellent, essentially no angle dependence can be detected. The proposed design is also simple in its construction, and indicates less expensive production technology than using conventional LEDs. Finally, the mechanical building height is low, in particular in the advantageous embodiment with combined electrode for PLED and touch sensor.

The foregoing has described the principles, preferred embodiments and modes of operation of the present invention. However, the invention should not be construed as being limited to the particular embodiments discussed above, which should be regarded as illustrative rather than restrictive, and it should be appreciated that variations may be made in those embodiments by workers skilled in the art without departing from the scope of the present invention, as defined by the following claims.

## Claims

1. Input interface for an electronic device, comprising a transparent touch-sensitive input detection layer (102), an input sensor (201) connected to said layer for detecting touch-generated capacitance variations in said detection layer, and a polymer layer (103) of a polymer light emitting diode (PLED) disposed under said detection layer and devised to emit light through said detection layer, which polymer layer is sandwiched between a pair of conductive electrode layers (102,104) of said polymer light emitting diode, **characterised in that** said detection layer forms one of said pair of electrode layers.

2. The input interface as recited in claim 1, **characterised in that** said detection layer is an anode for said light emitting diode.

3. The input interface as recited in claim 1, **characterised in that** said detection layer comprises an indium-tin-oxide substrate.

4. The input interface as recited in claim 1, **characterised in that** said polymer layer comprises an undoped conjugated polymer.

5. The input interface as recited in any of the preceding claims, **characterised in that** said input sensor is coupled to said detection layer through a DC-voltage blocking capacitor (203).

6. The input interface as recited in any of the preceding claims 1-4, **characterised in that** said detection layer is coupled to a switch (301), which switch is coupled to said input sensor and to a drive unit (105) for said polymer light emitting diode, which switch is devised to switch between connecting said detection layer to either said input sensor or said drive unit.

7. The input interface as recited in any of the preceding claims, **characterised in that** a transparent protective layer (101) is disposed over said detection layer.

8. The input interface as recited in any of the preceding claims, **characterised in that** a control unit (202) is connected to said input sensor and to a drive unit (105) for said polymer light emitting diode, which control unit is devised to control said drive unit to activate light emission from said polymer light emitting diode dependent on an input signal sensed by said input sensor.

9. The input interface as recited in any of the preceding claims, **characterised in that** said detection layer comprises a plurality of separate segments (401,402) representing separate input areas.

10. The input interface as recited in claim 9, **characterised in that** a continuous polymer layer (103) of said polymer light emitting diode is disposed under said plurality of separate segments of the detection layer.

11. The input interface as recited in claim 9, **characterised in that** separate polymer layer portions (501,502) are disposed under said plurality of separate segments of the detection layer.

12. Electronic device (701) comprising the input interface of claim 1.

13. The electronic device as recited in claim 12, **characterised by** the features of any of claims 2-11.

14. The electronic device as recited in claim 12, **characterised in that** said electronic device includes a radio communication terminal.

15. The electronic device as recited in claim 12, **characterised in that** said electronic device includes a media player.

## Patentansprüche

1. Eingabeschnittstelle für eine elektronische Vorrichtung, aufweisend eine transparente berührungssensitive Eingabeerfassungsschicht (102), einen Eingabesensor (201), der mit der Schicht zum Erfassen der durch eine Berührung erzeugter Kapazitäts-Veränderungen verbunden ist, und eine Polymerschicht (103) einer Licht aussendenden Polymerdiode (PLED), die unter der Erfassungsschicht positioniert und vorgesehen ist, Licht durch die Erfassungsschicht auszusenden, wobei die Polymerschicht zwischen einem Paar leitender Elektrodenschichten (102, 104) der Licht aussendenden Polymerdiode in einer Sandwichbauweise eingebracht ist, **dadurch gekennzeichnet, dass** die Erfassungsschicht eine von dem Paar der Elektrodenschichten bildet.

2. Eingabeschnittstelle, gemäß Anspruch 1, **dadurch gekennzeichnet, dass** die Erfassungsschicht eine Anode der das Licht aussendenden Diode ist.

3. Eingabeschnittstelle, gemäß Anspruch 1, **dadurch gekennzeichnet, dass** die Erfassungsschicht ein Indium-Zinn-Oxid-Substrat aufweist.

4. Eingabeschnittstelle, gemäß Anspruch 1, **dadurch gekennzeichnet, dass** die Polymerschicht ein undotiertes konjugiertes Polymer aufweist.

5. Eingabeschnittstelle, gemäß einem der vorhergehenden Ansprüche, **dadurch gekennzeichnet, dass** der Eingabesensor in die Erfassungsschicht durch einen DC-Spannung blockierenden Kondensator (203) eingekoppelt ist.

6. Eingabeschnittstelle, gemäß einem der vorhergehenden Ansprüche 1-4, **dadurch gekennzeichnet, dass** die Erfassungsschicht mit einem Schalter (301) gekoppelt ist, wobei der Schalter mit dem Eingabesensor und einer Ansteuereinheit (105) für die Licht aussendende Polymerdiode gekoppelt ist, wobei der Schalter vorgesehen ist zwischen dem Verbinden der Erfassungsschicht mit entweder dem Eingabesensor oder der Steuereinheit umzuschalten.

7. Eingabeschnittstelle, gemäß einem der vorhergehenden Ansprüche, **dadurch gekennzeichnet, dass** eine transparente schützende Schicht (101) über der Erfassungsschicht positioniert ist.

8. Eingabeschnittstelle, gemäß einem der vorhergehenden Ansprüche, **dadurch gekennzeichnet, dass** eine Steuereinheit (202) mit dem Eingabesensor und einer Ansteuereinheit (105) für die Licht aussendende Polymerdiode verbunden ist, wobei die Steuereinheit vorgesehen ist, die Ansteuereinheit zu steuern, um die Lichtaussendung durch die Licht aussendende Polymerdiode abhängig von einem durch den Eingabesensor erfasstem Eingabesignal zu aktivieren.

9. Eingabeschnittstelle, gemäß einem der vorhergehenden Ansprüche, **dadurch gekennzeichnet, dass** die Erfassungsschicht eine Vielzahl separater Segmente (401, 402), die separate Eingabebereiche repräsentieren, aufweist.

10. Eingabeschnittstelle, gemäß Anspruch 9, **dadurch gekennzeichnet, dass** eine durchgehende Polymerschicht (103) der Licht aussendenden Polymerdiode unter der Vielzahl separater Segmente der Erfassungsschicht positioniert ist.

11. Eingabeschnittstelle, gemäß Anspruch 9, **dadurch gekennzeichnet, dass** separate Polymerschicht-Abschnitte (501, 502) unter der Vielzahl separater Segmente der Erfassungsschicht positioniert sind.

12. Elektronisches Gerät (701) aufweisend die Eingabeschnittstelle nach Anspruch 1.

13. Elektronisches Gerät, gemäß Anspruch 12, **gekennzeichnet durch** die Merkmale gemäß irgendeinem der Ansprüche 2-11.

14. Elektronisches Gerät, gemäß Anspruch 12, **dadurch gekennzeichnet, dass** das elektronische Gerät ein Funkkommunikationsgerät beinhaltet.

15. Elektronisches Gerät, gemäß Anspruch 12, **dadurch gekennzeichnet, dass** das elektronische Gerät ein Medien-Abspielgerät beinhaltet.

## Revendications

1. Interface d'entrée pour dispositif électronique, comprenant une couche transparente de détection d'entrée sensible au toucher (102), un capteur d'entrée (201) connecté à ladite couche pour détecter des variations de capacité générées par toucher dans ladite couche de détection, et une couche polymère (103) d'une diode électroluminescente polymère (PLED pour "Polymer Light Emitting Diode") disposée sous ladite couche de détection et conçue pour émettre de la lumière à travers ladite couche de détection, laquelle couche polymère étant intercalée entre une paire de couches d'électrodes conductrices (102, 104) de ladite diode électroluminescente polymère, **caractérisée en ce que** ladite couche de détection forme l'une de ladite paire de couches d'électrodes.

2. Interface d'entrée selon la revendication 1, **caractérisée en ce que** ladite couche de détection est une anode pour ladite diode électroluminescente.

3. Interface d'entrée selon la revendication 1, **caractérisée en ce que** ladite couche de détection comprend un substrat d'oxyde d'indium-étain.

4. Interface d'entrée selon la revendication 1, **caractérisée en ce que** ladite couche polymère comprend un polymère conjugué non dopé.

5. Interface d'entrée selon l'une quelconque des revendications précédentes, **caractérisée en ce que** ledit capteur d'entrée est couplé à ladite couche de détection par l'intermédiaire d'un condensateur (203) de blocage de la tension continue.

6. Interface d'entrée selon l'une quelconque des revendications 1 à 4 précédentes, **caractérisée en ce que** ladite couche de détection est reliée à un commutateur (301), lequel commutateur est relié audit capteur d'entrée et à une unité d'attaque (105) pour ladite diode électroluminescente polymère, lequel commutateur est conçu pour commuter entre la connexion de ladite couche de détection à l'un quelconque desdits capteurs d'entrée ou à ladite unité d'attaque.

7. Interface d'entrée selon l'une quelconque des revendications précédentes, **caractérisée en ce qu'**une couche de protection transparente (101) est disposée sur ladite couche de détection.

8. Interface d'entrée selon l'une quelconque des revendications précédentes, **caractérisée en ce qu'**une unité de commande (202) est connectée audit capteur d'entrée et à une unité d'attaque (105) pour ladite diode électroluminescente polymère, laquelle unité de commande est conçue pour commander ladite unité d'attaque pour activer l'émission de lumière à partir de ladite diode électroluminescente polymère en fonction d'un signal d'entrée détecté par ledit capteur d'entrée.

9. Interface d'entrée selon l'une quelconque des revendications précédentes, **caractérisée en ce que** ladite couche de détection comprend une pluralité de segments séparés (401, 402) représentant des zones d'entrée séparées.

10. Interface d'entrée selon la revendication 9, **caractérisée en ce qu'**une couche polymère continue (103) de ladite diode électroluminescente polymère est disposée sous ladite pluralité de segments séparés de la couche de détection.

11. Interface d'entrée selon la revendication 9, **caractérisée en ce que** des parties de couche polymère séparées (501, 502) sont disposées sous ladite pluralité de segments séparés de la couche de détection.

12. Dispositif électronique (701) comprenant l'interface d'entrée de la revendication 1.

13. Dispositif électronique selon la revendication 12, **caractérisé par** les éléments caractéristiques de l'une quelconque des revendications 2 à 11.

14. Dispositif électronique selon la revendication 12, **caractérisé en ce que** ledit dispositif électronique comporte un terminal de communication radio.

15. Dispositif électronique selon la revendication 12, **caractérisé en ce que** ledit dispositif électronique comprend un lecteur multimédia.
